**Europäisches Patentamt**

(19) **European Patent Office**

**Office européen des brevets**

(11) Numéro de publication: **0 022 938**
**B1**

(12) **FASCICULE DE BREVET EUROPEEN**

(45) Date de publication du fascicule du brevet: **19.09.84**

(21) Numéro de dépôt: **80103547.8**

(22) Date de dépôt: **24.06.80**

(51) Int. Cl.³: **H 03 H 11/48,** H 01 F 19/00, H 04 Q 3/52

(54) **Dispositif pour augmenter l'inductance parallèle des transformateurs de lignes téléphoniques.**

(30) Priorité: **20.07.79 FR 7919131**

(43) Date de publication de la demande:
**28.01.81 Bulletin 81/04**

(45) Mention de la délivrance du brevet:
**19.09.84 Bulletin 84/38**

(84) Etats contractants désignés:
**CH DE FR GB LI**

(56) Documents cités:
**FR-A-2 173 899**
**US-A-3 965 447**

**IBM TECHNICAL DISCLOSURE BULLETIN vol. 9, no. 10, mars 1967 New York US J. BEYSSERE et al.: "Junctor Circuit for Voice and Date Exchange", pages 1440-1441**

(73) Titulaire: **International Business Machines Corporation**
**Old Orchard Road**
**Armonk, N.Y. 10504 (US)**

(72) Inventeur: **Morlec, Emile**
**Le Magdeleine Chemin de Saint Laurent**
**F-06170 Cros de Cagnes (FR)**
Inventeur: **Reynes, Daniel**
**La Bastide Langue**
**F-06270 Villeneuve Loubet (FR)**
Inventeur: **Suzzoni, Jean-Pierre**
**Le val des Fleurs, 72 avenue des Tuilières**
**F-06170 Cros de Cagnes (FR)**

(74) Mandataire: **Bonin, Jean-Jacques**
**Compagnie IBM France Département de Propriété Industrielle**
**F-06610 La Gaude (FR)**

Courier Press, Leamington Spa, England.

## Description

### Domaine Technique

La présente invention concerne un dispositif pour augmenter l'inductance parallèle des transformateurs de lignes téléphoniques d'après le préambule de la revendication 1.

On sait que, dans un poste téléphonique conventionnel, l'énergie fournie au microphone par l'utilisateur lorsqu'il parle est appliquee a un transformateur hybride qui en transmet une partie dans la ligne téléphonique elle-même et une autre partie dans une impédance d'équilibrage. Si cette impédance n'est pas exactement identique à celle de la ligne, une partie de l'énergie est transmise dans l'écouteur: c'est l'effet connu sous le nom d'"antilocal". Ce retour vers l'écouteur est nécessaire, mais il est néanmoins souhaitable qu'il se limite à un niveau approprié, car il est bien connu que l'utilisateur parle d'autant plus bas que l'intensité acoustique de ce retour est plus forte. Afin de ramener cet effet à de justes proportions les caractéristiques de l'impédance d'équilibrage sont choisies en fonction de l'impédance de la ligne à laquelle il est raccordé. Les postes téléphoniques conventionnels étant principalement destinés à être raccordés à des lignes et des centraux PTT, l'impédance d'équilibrage qui y est incorporée est adaptée à celle des lignes et centraux PTT: elle est généralement constituée par un réseau résistance-capacité.

Lorsqu'un poste téléphonique muni d'une telle impédance d'équilibrage est utilisé dans un auto-commutateur privé, il devient alors necessaire que le réseau de commutation de l'auto-commutateur soit parfaitement "transparent" si l'on veut que l'impédance d'équilibrage remplisse correctement sont office. Si, comme c'est souvent le cas dans les auto- commutateurs électroniques, les transformateurs de ligne ont une inductance faible, l'équilibrage n'est plus réalisé. Pour resoudre ce problème on est alors conduit à augmenter la valeur des inductances parallèles de l'auto-commutateur.

### Technique Antérieure

Une solution simple consiste à prévoir un transformateur de ligne dont les enroulements présentent une inductance élevée. Cette solution présente l'inconvénient d'augmenter considérablement le volume et le prix du transformateur, et elle est donc à la fois peu compatible avec les techniques de miniaturisation actuelles et peu économiques.

Une autre solution, préconisée dans FR A 2 173 899, consiste à connecter un réseau de compensation, réalisant une impédance inductive negative, en parallèle aux bornes de l'enroulement primaire du transformateur. Cette solution présente l'inconvénient de nécessiter autant de réseaux de compensation qu'il y a de transformateurs et donc, de grever le coût de l'ensemble.

On connait également, d'après l'article paru dans l'IBM Technical Disclosure Bulletin, Volume 9, N° 10, Mars 1967, pages 1440—1441, un réseau de commutation à matrices d'interrupteurs de points de croisement comprenant une série d'entrées et une série de sorties dont le nombre est inférieur au nombre desdites entrées, chaque secondaire de transformateur de ligne étant relié à une entrée dudit réseau et pouvant être connecté sélectivement à travers lesdites matrices avec l'une quelconque desdites sorties pour réaliser un chemin électrique continu entre une entrée et une sortie en vue de la transmission d'informations, lesdites sorties du réseau étant reliées par paires à des joncteurs qui lorsqu'ils sont actives, permettent de connecter électriquement les deux sorties auxquelles ils sont reliés, et comprenant un élément à resistance négative intégré en série dans chaque joncteur pour compenser les pertes série du réseau. Cependant le réseau en question ne comporte aucun dispositif permettant de compenser les pertes parallèles des transformateurs de ligne.

La présente invention apporte une solution qui ne comporte pas les inconvénients de l'art anterieur et qui est réalisée par les caractéristiques caractériscuites de la revendication 1.

### Expose de l'Invéntion

Selon l'invention, on obtient une augmentation de l'inductance parallèle des transformateurs de ligne dans un reseau de commutation spatial à joncteurs médians en incorporant des dispositifs à inductance négative au niveau des joncteurs au lieu de les connecter sur les secondaires des transformateurs. Ceci présente l'avantage de ne nécessiter qu'un nombre notablement plus faible de ces dispositifs et donc de réaliser une économie substantielle. La connexion de ces dispositifs inductifs au niveau des joncteurs permet de plus, de commander très aisément la mise en circuit ou hors circuit de ces dispositifs ce qui améliore le fonctionnement de l'ensemble.

D'autres objets et avantages ainsi que des niodes de réalisation de la présente invention ressortiront mieux de l'exposé qui suit, fait en référence aux dessins annexés à ce texte, qui représentent divers modes de réalisation préférés de celle- ci.

### Brève description des figures

La figure 1 représente schématiquement, un circuit conventionnel de ligne téléphonique, ainsi qu'un chemin dans un réseau de commutation entre deux transformateurs de ligne, par l'intermédiaire d'un joncteur médian.

La figure 2 donne un exemple de réalisation de la résistance négative 32 de la figure 1.

La figure 3 représente schématiquement un dispositif permettant de compenser les pertes parallèles d'un transformateur de ligne.

La figure 4 represente schématiquement une inductance négative typique utilisée dans le dispositif de l'invention.

La figure 5 représente un mode de réalisation du dispositif de l'invention où les inductances négatives sont disposées au niveau des joncteurs médians du réseau de commutation.

La figure 6 représente une variante du dispositif de la figure 5.

La figure 7 montre comment une inductance telle que celle représentée à la figure 4 peut être montée dans le dispositif de la figure 5.

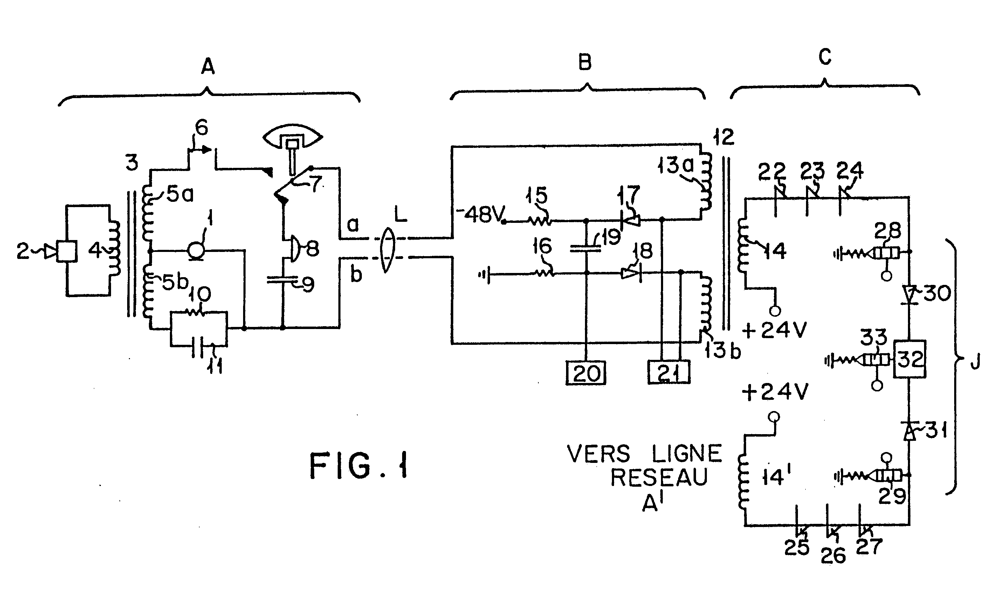

Sur la figure 1, on a représenté très schématiquement en A les éléments fondamentaux d'un poste téléphonique conventionnel, en L la ligne téléphonique reliant le poste A à un central privé, en B un circuit de ligne et en C et J les éléments du réseau de commutation du central privé et un joncteur médian intervenant pour réaliser la connexion entre le poste A et une ligne réseau A' (non représentée).

L'ensemble représenté dans cette figure correspond sensiblement à celui decrit dans l'IBM Technical Disclosure Bulletin cité plus haut, et n'est décrit que pour mieux comprendre le contexte de l'invention.

Le post téléphonique A comporte essentiellement:

. un microphone 1 et un écouteur 2,
. un transformateur 3 comportant un enroulement primaire 4 et deux enroulements secondaires identiques montés en série 5a et 5b,
. un interrupteurs de cadran d'appel 6,
. un commutateur de crochet 7,
. une sonnerie 8 avec son condensateur 9,
. un circuit d'équilibrage composé d'une résistance 10 et d'une capacité 11.

Les courants vocaux en provenance d'un autre abonné transmis par la ligne L au poste A traversent les enroulements 5a et 5b dans la même sens, et induisent un courant dans l'enroulement 4. L'écouteur 2 les transforme en signaux audibles.

Par contre les courants vocaux en provenance du microphone 1 et transmis par la ligne L vers le central circulent en sens inverse dans les enroulements 5a et 5b du transformateur 3. Si l'impédance du circuit d'équilibrage est égale à celle de la ligne vue des bornes a et b du poste A, les courants circulant dans les enroulements 5a et 5b étant égaux et opposés, aucun courant n'est induit dans l'enroulement 4. L'utilisateur n'entend donc pas sa voix dans l'écouteur. Si l'équilibrage n'est pas parfait, les courants circulant dans les enroulements 5a et 5b ne sont pas égaux et un certain courant est induit dans l'enroulement 4. L'utilisateur entend alors sa voix dans l'écouteur, plus ou moins faiblement selon le degré d'équilibrage du circuit.

Le circuit de ligne B comporte essentiellement:

. un transformateur de ligne 12 comportant un primaire 13 constitué de deux enroulements identiques 13a et 13b et un secondaire 14,
. deux résistances d'alimentation 15 et 16,
. deut diodes 17 et 18,
. un condensateur de découplage 19,
. une source de tension de —48V,
. un circuit de détection de courant de boucle 20,
. un circuit d'injection de courant de sonnerie 21.

Lorsque le combine du poste A est en position de repos le commutateur de crochet 7 maintient le circuit de boucle ouvert (comme sur la figure) et aucun courant continu ne circule dans ce circuit. Par contre un courant de sonnerie injecté par le circuit 21 peut venir actionner la sonnerie 8.

Au contraire, lorsque l'utilisateur a decroché son combiné, un courant continu circule dans la boucle à partir de la masse vers le —48V en passant successivement par la diode 18, l'enroulement 13b, la résistance 10, les enroulements 5b et 5a, l'enroulement 13a, la diode 17 et la résistance 15. La présence ou l'absence de ce courant est détectée par le circuit 20, qui transmet cette information à un organe de contrôle (non représenté) pour la traiter et élaborer les ordres appropriès pour opérer les connexions ou déconnexions nécessaires.

Sous la référence C, on a représenté très schématiquement un chemin pour les signaux vocaux à travers le réseau de commutation du central, entre le secondaire 14 du transformateur de ligne 12 de l'abonné A et le secondaire 14' du transformateur de ligne réseau (non représenté) A' avec laquelle il a été raccordé.

Dans cet exemple le reseau de commutation est du type à plusieurs étages de matrices, replié sur lui-même, et dont les interrupteurs de points de croisement sont constitués par des redresseurs commandés (très schématiquement representés en 22, 23, 24, 25, 26, 27).

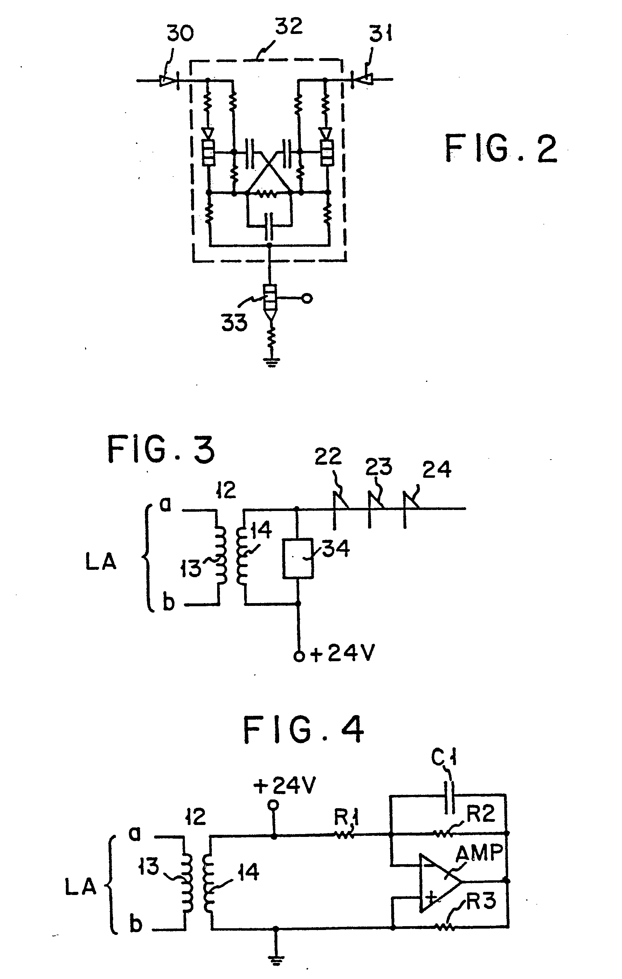

Le joncteur médian J comporte deux transistors 28 et 29 fonctionnant en puits de courant, deux diodes 30 et 31, une résistance négative 32 (pour compenser les pertes série) et un transistor 33. Le schéma detaillé d'un circuit à résistance négative pouvant être utilisé est donne à la figure 2.

La connexion entre l'abonné A et la ligne réseau A' s'effectue en deux temps. Tout d'abord on établit deux demi-chemins à courant continu s'étendant d'une part depuis la source de 24V vers la masse du transistor 28 et d'autre part depuis la source de 24V vers la masse du transistor 29; l'établissement de chacun de ces chemins est réalisé en commandant la base des transistors (28 et 29) et les électrodes de commande des redresseurs commandes (22, 23, 24 et 25, 26, 27). Ensuite on commande la base du transistor 33, ce qui a pour effet de rendre les diodes 30 et 31 conductrices et de réaliser la connexion vocale entre les deux demi-chemins précédemment établis.

Une façon simple, mais peu économique de resoudre le problème de la compensation des pertes parallèles consisterait, ainsi qu'on l'a représenté schématiquement à la figure 3, à connecter sur les bornes de l'enroulement secondaire 14 du transformateur de ligne 12 un dispositif 34 se comportant comme une inductance négative.

Si on appelle LP la valeur de l'inductance du transformateur 12 et —L la valeur de l'inductance négative 34, l'inductance apparente LA de la ligne vue des fils a b sera:

$$LA = \frac{LP \times (-L)}{LP - L}$$

On voit ainsi qu'il est aisé de donner à l'inductance apparente LA n'importe quelle valeur élevée désirée en utilisant une inductance négative de valeur appropriee. Plus l'inductance apparente voulue sera grande, plus on choisira la valeur absolue de L proche de celle de LP (mais supérieure à LP de façon que le rapport soit positif).

On a représenté à la figure 4 un circuit conventionnel se comportant comme une inductance négative, pouvant être avantageusement utilise dans le dispositif de la figure 3 ou dans celui de la présente invention. Ce circuit comprend seulement trois résistances R1, R2, R3, un condensateur C1 et un amplificateur opérationnel AMP, et peut donc être realisé sous un encombrement et un prix très faibles.

Si l'on appelle LP l'inductance du transformateur 12 et LA 'inductance apparente de la ligne vue des points a, b on aura:

$$LA = \frac{LP \times (-C1 \times R1 \times R3)}{LP - (C1 \times R1 \times R3)}$$

On voit facilement qu'en choisissant des valeurs appropriées pour les éléments R1, R3 et C1 on peut amener l'inductance apparente LA à prendre n'importe quelle valeur élevée désirée. Il suffit pour cela de choisir le produit C1×R1×R3 suffisamment voisin de la valeur de LP mais plus grand que LP, de façon que le rapport donne une valeur positive pour LA.

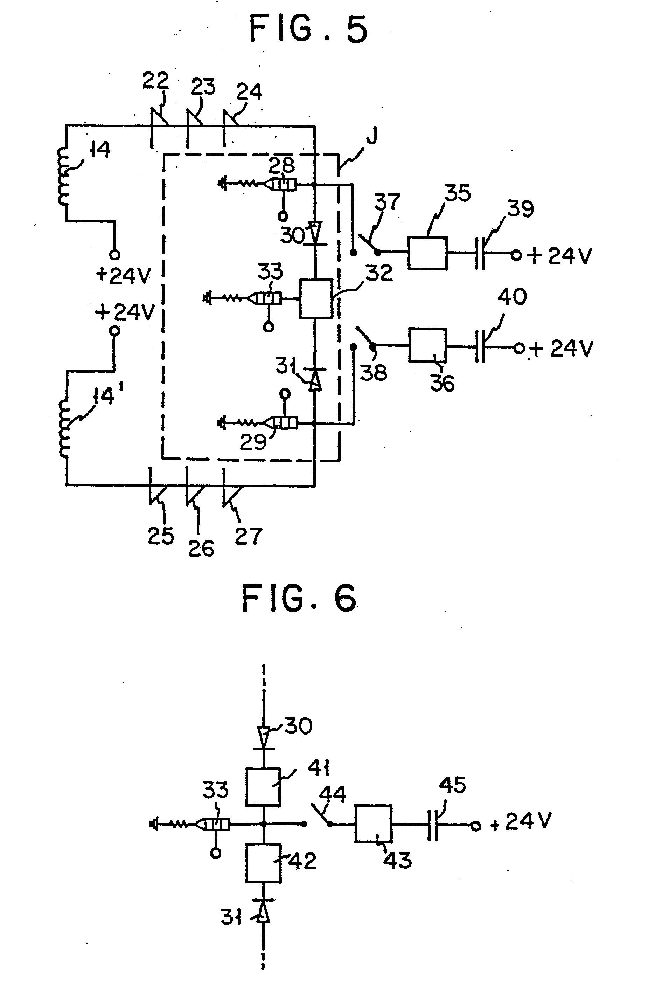

Sur la figure 5, on a représenté un premier mode de réalisation de l'invention. Dans ce dernier, au lieu de placer une inductance négative en parallèle sur chacun des enroulements secondaires des transformateurs de lignes comme ce serait le cas si on employait le dispositif de la figure 3, on a disposé les inductances négatives au niveau des joncteurs. En effet les joncteurs etant en nombre très inferieur à celui des transformateurs de ligne, on réalise ainsi une économie très sensible. On peut voir sur la figure 5, des inductances negatives 35 et 36 connectées respectivement entre les anodes des diodes 30 et 31 et la source de +24V par l'intermédiaire d'interrupteurs 37 et 38 et de condensateurs 39 et 40. Les interrupteurs 37 et 38 sont destinés à mettre ces inductances hors circuit lorsque le joncteurs est au repos, de façon à ce que les inductances n'apportent aucune perturbation. La commande de ces interrupteurs peut être par exemple couplée avec celle des transistors 28 et 29, ou celle du transistor 33.

Les condensateurs 39 et 40 sont destinés à empêcher le passage du courant continu dans les inductances 35 et 36.

La valeur de chacune des inductances 35, 36 est adaptée pour augmenter l'inductance parallèle d'un transformateur de ligne, de la façon désirée.

La figure 6 montre une variante du circuit précédent dans laquelle on n'utilise qu'une seule inductance négative pour augmenter l'inductance de deux transformateur de ligne. Pour cela il faut remplacer la résistance négative 32 du circiuit de la figure 5 par deux résistances négative de valeur moitié 41 et 42, et connecter l'inductance négative unique 43 entre les deux résistances négatives et le +24V (tourjours préférablement par l'intermédiaire d'un interrupteur tel que 44 et d'un condensateur tel que 45). L'inductance négative unique 43 doit bien entendu avoir une valeur appropriée pour augmenter l'inductance parallèle de deux transformateurs de lignes, de la façon désirée.

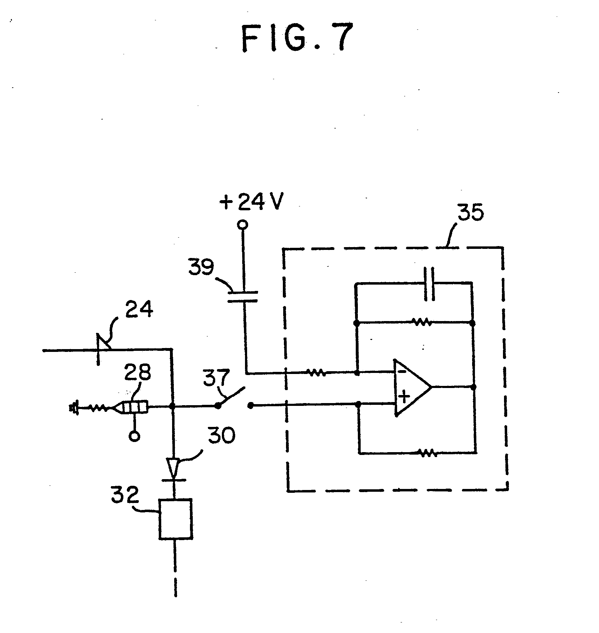

On a représenté sur la figure 7 le montage d'une inductance négative du type de celle montrée à la figure 4 dans un dispositif selon l'invention tel que celui représenté á la figure 5.

Bien que l'on ait décrit dans ce qui précède et représenté sur les dessins les caractéristiques essentielles de l'invention appliquées à des modes de réalisation préférés de celle-ci, il est évident que l'homme de l'art peut y apporter toutes modifications de forme ou de détail qu'il juge utiles, sans pour autant sortir du cadre de ladite invention.

## Revendications

1. Dispositif pour augmenter l'inductance parallèle des transformateurs de ligne téléphoniques dans un réseau de commutation à matrices d'interrupteurs de points de croisement (22, 23, 24) comprenant une série d'entrées et une série de sorties dont le nombre est inférieur au nombre desdites entrées, chaque secondaire (14) de transformateur de ligne (12) étant relie à une entrée dudit réseau et pouvant être connecté sélectivement à travers lesdites matrices avec l'une quelconque desdites sorties pour réaliser un chemin électrique continu entre une entrée et une sortie en vue de la transmission d'informations, caractérisé en ce qu'il comporte des éléments à inductance négative (35) connectés sur lesdites sorties, de façon que lorsqu'un chemin électrique est établi entre un secondaire de transformateur de ligne et une sortie, l'élément à inductance négative correspondant soit électriquement connecté en parallèle sur le secondaire dudit transformateur, ledit élément à inductance négative étant automatiquement branché en parallèle sur ledit secondaire lorsque la ligne correspondante est mise en service et débranché lorsque cette ligne n'est plus en service, et le même élément à inductance négative étant utilisé pour augmenter ainsi successivement l'inductance parallèle de plusieurs transformateurs de lignes reliés par l'intermédiaire de matrices à une même sortie du réseau au fur et à mesure de leur mise en service.

2. Dispositif selon la revendication 1 dans lequel:

lesdits interrupteurs de point de croisement sont des semi-conducteurs,

l'enroulement secondaire (14) dudit transformateur de ligne est connecté d'une part à une première source de tension et d'autre part à une entrée dudit réseau,

chaque sortie dudit réseau est connectée à une seconde source de tension par l'intermédiaire d'un premier interrupteur (28) et à la première borne d'une diode (30), la différence de potentiel entre lesdites première et seconde sources de tension étant dans un sens polarisant en direct lesdits semi-conducteurs, et

la seconde borne de ladite diode est connectée à une troisième source de tension par l'intermédiaire d'un second interrupteur (33), la différence de potentiel entre ladite première source et ladite troisième source étant dans un sens polarisant en direct ladite diode,

caractérisé en ce que:

ledit élément à inductance négative (35) est connecté entre ladite première borne de ladite diode et ladite première source de tension.

3. Dispositif selon la revendication 3 dans lequel:

lesdites sorties du réseau sont reliées par paires à des joncteurs (5) qui, lorsqu'ils sont activés, permettent de connecter électriquement les deux sorties auxquelles ils sont reliés,

le réseau est du type dans lequel chaque joncteur comporte deux interrupteurs (28, 29) connectés respectivement d'une part à deux sorties dudit réseau et d'autre part à ladite seconde source de tension, deux diodes (30, 31) connectées respectivement d'une part auxdites deux sorties dudit réseau et d'autre part à une troisième source de tension par l'intermédiaire d'un même second interrupteur (33), et

une résistance négative (32), pour compenser les pertes série du réseau, est interposée entre lesdites deux diodes (30, 31),

caractérisé en ce que:

deux éléments à inductance négative (35, 36) sont connectés l'un entre la première borne de la première diode (30) et ladite première source de tension, et l'autre entre la première borne de la seconde diode (31) et ladite première source de tension.

4. Dispositif selon la revendication 2, dans lequel:

lesdites sorties du réseau sont reliées par paires à des joncteurs (5) qui, lorsqu'ils sont activés, permettent de connecter électriquement les deux sorties auxquelles ils sont reliés et

le réseau est du type dans lequel chaque joncteur comporte deux interrupteurs (28, 29) connectés respectivement d'une part à deux sorties dudit réseau et d'autre part à ladite seconde source de tension, deux diodes (30, 31) connectées respectivement d'une part auxdites deux sorties dudit réseau et d'autre part à une troisième source de tension par l'intermédiaire d'un même second interrupteur (33),

caractérisé en ce que:

deux résistances négatives (41, 42) pour compenser les pertes séries dudit réseau sont interposées en série entre lesdites deux diodes (30, 31) et

un élément à inductance négative (43) est connecté entre le point commun auxdites deux résistances négative et ladite première source de tension.

5. Dispositif selon la revendication 1 ou 2 ou 3 caractérisé en ce que la valeur dudit élément à inductance négative (35) est choisie de façon à ce que, lorsqu'il est connecté en parallèle avec le secondaire (14) dudit transformateur ce dernier présente l'inductance apparente désirée.

6. Dispositif selon la revendication 4, caractérisé en ce que la valeur dudit élément à inductance négative (43) est choisie de façon à ce que, lorsqu'il est connecté en parallèle avec les secondaires (14, 14') desdits deux transformateurs de ligne, chacun de ceux-ci présente l'inductance apparente désirée.

7. Dispositif selon l'une quelconque des revendications 1 à 6, caractérisé en ce qu'un interrupteur (37, 38, 44) est interposé dans le circuit comprenant ledit élément à inductance négative (35, 36, 43).

8. Dispositif selon l'une quelconque des revendications 1 à 7, caractérisé en ce qu'un condensateur (39, 40, 45) est interposé dans le circuit comprenant ledit élément à inductance négative (35, 36, 43).

**Patentansprüche**

1. Vorrichtung zur Erhoehung der parallelen Induktivitaet von Transformatoren fuer Telefonleitungen in einem Koppelfeld mit Vermittlungsmodulen mit Schaltern (22, 23, 24), die eine Reihe von Eingaben une eine Reihe von Ausgaben aufweist, wobei die Anzahl der Ausgaben kleiner als die Anzahl der Eingaben ist, jede Sekundaerwicklung (14) eines Leitungstransformators (12) mit einer Eingabe des Koppelfelds verbunden ist und wahlweise ueber die Vermittlungsmodulen an irgendeine Ausgabe angeschlossen werden kann, so dass eine elektrische kontinuierliche Strecke zwischen einer Eingabe und einer Ausgabe zum Zweck der Nachrichtoneuebertragung hergestellt wird, dadurch gekennzeichnet, dass die Vorrichtung an die Ausgaben angeschlossene Elemente negativer Induktant (35) aufweist, so dass, wenn ein elektrische Strecke zwischen einer Sekundaerwicklung eines Leitungstransformators und einer Ausgabe hergestellt wird, das entsprechende Element negativer Induktant parallel elektrisch an die Sekundaerwicklung des Leitungstransformators angeschlossen wird, wobei das Element negativer Induktant automatisch parallel mit der Sekundaerwicklung gekoppelt wird, wenn diese Leitung in Betrieb gesetzt ist, und entkoppelt ist, wenn diese Leitung nicht mehr in Betrieb ist, und wobei das gleiche Element negativer Induktanz zur progressiven Erhoehung der parallelen Induktivitaet von mehreren ueber Vermittlungsmodulen mit einer gleichen Ausgabe des Koppelfeldes verbundenen Leitungstransformatoren bei deren progressivem Inbetriebssetzen verwendet wird.

2. Vorrichtung nach Anspruch 1, in der:

die Schalter Halbleiter sind,
die Sekundaerwichlung (14) des Leitungstransformators einerseits mit einer ersten Spannungsquelle und andererseits mit einer Eingabe des Koppelfeldes verbunden ist,
jede Ausgabe des Koppelfeldes mit einer zweiten Spannungsquelle ueber einen ersten Schalter (28) und mit der ersten Klemme einer Diode (30) verbunden ist, wobei die Spannungsdifferenz zwischen der ersten und der zweiten Spannungsquelle so gewählt ist, daß die Diode in Durchlassrichtung betrieben wird,

dadurch gekennzeichnet, dass:

das Element negativer Induktanz (35) zwischen der ersten Klemme der Diode und der ersten Spannungsquelle verbunden ist.

3. Vorrichtung nach Anspruch 3, in der:

die Ausgaben des Koppelfeldes paarweise mit Vermittlungselementen (5) verbunden sind, die die elektrische Kopplung der der zwei mit den letzteren gekoppelten Ausgaben gestattet, wenn die Vermittlungselemente betrieben sind,
das Koppelfeld der Gattung ist, in der jedes Vermittlungselement zwei jeweils einerseits mit zwei Ausgaben des Koppelfeldes und andererseits mit der zweiten Spannungsquelle verbundene Schalter (28, 29), zwei jeweils einerseits mit den zwei Ausgaben des Koppelfeldes und andererseits mit einer dritten Spannungsquelle ueber einen gleichen zweiten Schalter (33) verbundene Dioden (30, 31), und
ein negativer Widerstand (32) zum Ausgleichen der Serienverlustleistung zwischen den zwei Dioden (30, 31) vorgesehen sind,

dadurch gekennzeichnet, dass

zwei Elemente negativer Induktivitaet (35, 36) das eine zwischen der ersten Klemme der ersten Diode (30) und der ersten Spannungsquelle und das andere zwischen der erstem Klemme der zweiten Diode (31) und der ersten Spannungsquelle verbunden sind.

4. Vorrichtung nach Anspruch 2, in der:

die Ausgaben des Koppelfeldes paarweise mit Vermittlungselementen (5) verbunden sind, die die elektrische Kopplung der zwei mit den Vermittlungselementen verbundenen Ausgaben gestattet, wenn sie betrieben sind,
das Koppelfeld der Gattung ist, in der jedes Vermittlungselement zwei jeweils einerseits mit zwei Ausgaben des Koppelfeldes und andererseits mit der zweiten Spannungsquelle verbundene Schalter (28, 29), zwei jeweils einerseits mit den zwei Ausgaben des Koppelfeldes und andererseits mit einer dritten Spannungsquelle ueber einen gleichen zweiten Schalter (33) verbundene Diode (30, 31) aufweist,

dadurch gekennzeichnet, dass

zwei negative Widerstaende (41, 42) zum Ausgleichen der Serienverlustleistung in dem Koppelfeld zwischen den zwei Dioden (30, 31) hintereinander zwischengeschaltet sind,
ein Element negativer Induktanz (43) zwischen dem zu den zwei negativen Widerstaenden gemeinsamen Punkt und der ersten Spannungsquelle verbunden ist.

5. Vorrichtung nach Anspruch 1 oder 2 oder 3, dadurch gekennzeichnet, dass der Wert das Elements negativer Induktanz (35) so ausgewaehlt ist, dass bei dessen paralleler Kopplung mit der Sekundaerwicklung (14) des zugeordneten Leitungstransformators der letztere die erwuenschte scheinbare Induktanz hat.

6. Vorrichtung nach Anspruch 4, dadurch gekennzeichnet, dass der Wert des Elements negativer Induktanz (43) so ausgewaehlt ist, dass bei dessen paralleler Kopplung mit den Sekundaerwicklungen (14, 14') der zwei jeweils zugeordneten Leitungstransformatoren jeder der letsteren die erwuenschte scheinbare Induktanz hat.

7. Vorrichtung nach einem der Ansprueche 1 bis 6, dadurch gekennzeichnet, dass ein Schalter (37, 38, 44) in der das Element negativer Induktanz (35, 36, 43) einschliessenden Schaltung zwischengeschaltet ist.

8. Vorrichtung nach einem der Ansprueche 1 bis 7, dadurch gekennzeichnet, dass ein Kondensator (39, 40, 45) in der das Element negativer Induktanz (35, 36, 43) einschliessenden Schaltung zwischengeschaltet ist.

## Claims

1. A device for increasing the parallel inductance of the telephone line transformers in a switching network incorporating matrices of crosspoint switches (22, 23, 24) comprising a series of inputs and a series of outputs the number of which is smaller than the number of said inputs, each line transformer (12) secondary winding (14) being connected to an input of said network and being selectively connectable through said matrices, to anyone of said outputs to provide a continuous electrical connection between an input and an output, for transmitting information, characterized in that it comprises negative inductance elements (35) connected to said outputs so that when an electrical connection is made between a line transformer secondary winding and an output, the corresponding negative inductance element appears as electrically connected in parallel to the secondary winding of said transformer, said negative inductance element being automatically connected in parallel to said secondary winding when the corresponding line is put into service, and disconnected when said corresponding line is no longer in service, and thus, the same negative inductance element being used for successively increasing the parallel inductance of a plurality of line transformers connected through matrices to a same output of the network as they are put into service.

2. A device as set forth in claim 1 in which:

— said crosspoint switches are comprised of semi conductor devices,
— secondary winding (14) of said line transformer is connected on the one hand, to a first voltage supply and, on the other hand, to an input of said network,
— each output of said network is connected to a second voltage supply through a first switch (28) and to the first terminal of a diode (30), the potential difference between said first and second voltage supplies being such that said semi conductor devices are forward biased,

— the second terminal of said diode is connected to a third voltage supply through a second switch (33), the potential difference between said first source and said third source being such that said diode is forward biased, characterized in that:
— said negative inductance element (35) is connected between said first terminal of said diode and said first voltage supply.

3. A device as set forth in claim 3 in which:

said network outputs are connected by pairs to junctors (5) which, when activated, provide an electrical connection between the two outputs connected thereto,

— the network is of the type wherein each junctor includes two switches (28, 29) respectively connected, on the one hand, to two outputs of said network and, on the other hand, to said second voltage supply, two diodes (30, 31) respectively connected on the one hand, to said two outputs of said network and, on the other hand, to a third voltage supply through same second switch (33) and
— a negative resistor (32) for compensating for the series current losses of the network, is provided between said two diodes (30, 31),

characterized in that:

— two negative inductance elements (35, 36) are respectively connected between the first terminal of first diode (30) and the first voltage supply, and between the first terminal of second diode (31) and said first voltage supply.

4. A device as set forth in claim 2, in which:

said network outputs are connected by pairs to junctors (5) which, when activated, provide an electrical connection between the two outputs connected thereto and

— the network is of the type in which each junctor comprises two switches (28, 29) respectively connected, on the one hand, to two outputs of said network and, on the other hand, to said second voltage supply, two diodes (30, 31) respectively connected on the one hand, to said two outputs of said network and on the other hand, to a third voltage supply through a same second switch (33),

characterized in that:

— two negative resistors (41, 42) for compensating for the series current losses of the network are mounted in series between said two diodes (30, 31) and
— a negative inductance element (43) is connected between the point common to said two negative resistors and said first voltage supply.

5. A device as set forth in claim 1 or 2 or 3 characterized in that the value of said negative inductance element (35) is selected so that, when it is connected in parallel with secondary winding (14) of said transformer, said transformer exhibits the desired apparent inductance.

6. A device as set forth in claim 4 characterized in that the value of said negative inductance element (43) is selected so that, when it is connected in parallel to secondary windings (14, 14') of said two line transformers, each of said transformers exhibits the desired apparent inductance.

7. A device as set forth in anyone of claims, 1 to 6 characterized in that a switch (37, 38, 44) is provided in the circuit comprising said negative inductance element (35, 36, 43).

8. A device as set forth in anyone of claims 1 to 7, characterized in that a capacitor (39, 40, 45) is provided in the circuit comprising said negative inductance element (35, 36, 43).

FIG. 1

FIG. 2

FIG. 3

FIG. 4

# FIG . 5

# FIG . 6

# FIG. 7